# EUROPÄISCHE PATENTSCHRIFT

(11) **EP 0 548 701 B1**
(45) Veröffentlichungstag und Bekanntmachung des Hinweises auf die Patenterteilung: **17.05.1995**
(21) Anmeldenummer: 92121105.8
(22) Anmeldetag: 11.12.1992
(51) Int. Cl.: H01R 13/506, H02B 1/048

(54) **Gehäuse, elektrischer Verbinder und Verbinderanordnung**
Electrical connector housing and connector arrangement
Boîtier de connecteurs électriques et agencement de connexion

(30) Priorität: 21.12.1991 DE 4142525
(43) Veröffentlichungstag der Anmeldung: 30.06.1993
(73) Patentinhaber: Delphi Automotive Systems Deutschland GmbH, D-42369 Wuppertal (DE)
(72) Erfinder: Lübstorf, Mario, Dipl.-Ing., W-5603 Wülfrath (DE); Jorroch, Waldemar, W-5630 Remscheid 11 (DE)
(74) Vertreter: Priebisch, Rüdiger

(56) Entgegenhaltungen:
- DE-U- 8 908 758
- FR-A- 2 153 752

## Beschreibung

Die Erfindung betrifft ein Gehäuse nach dem Oberbegriff des Patentanspruches 1, einen elektrischen Verbinder nach dem Oberbegriff des Patentanspruches 6 und eine Verbinderanordnung nach dem Oberbegriff des Patentanspruches 7.

Aus der Praxis sind Gehäuse für elektrische Steckverbinder bekannt, wie sie im Oberbegriff des Patentanspruches angegeben sind.
Derartige Gehäuse können oft nicht die Ansprüche an die Haltbarkeit und Festigkeit der Schnappverbindung zwischen Gehäusegrundkörper und Deckel befriedigen. Dies gilt in erhöhtem Maße, wenn die Gehäuse bei Steckverbindern in Kabelsätzen, insbesondere für die Verdrahtung von Automobilen, eingesetzt werden. Sowohl die rauhen Zustände beim Einbau in das Auto am Fließband als auch die vielfältigen Belastungen beim Gebrauch im Auto stellen hohe Ansprüche an die Schnappverbindung.

Der Erfindung liegt daher das Bestreben zugrunde, bei einem derartigen Gehäuse eine dauerhafte Verrastung der Gehäuseteile sicherzustellen und insbesondere die Verbindungskräfte zwischen den Gehäuseteilen zu erhöhen.

Die Erfindung schlägt hierzu vor, daß die Spitze des pfeilspitzartigen Teils nach dem Verbinden unter Spannung an dem anderen Gehäuseteil so anliegt, daß von der Spitze ausgehend eine Kraft auf die Widerhaken gerichtet ist, welche die Widerhaken auseinander zu bewegen bestrebt ist. Vorteilhafte Ausgestaltungen finden sich in den Merkmalen der Unteransprüche, des weiteren ein das Gehäuse umfassender elektrischer Verbinder und eine damit gebildete Verbinderanordnung.

Die Erfindung ist zwar anhand eines elektrischen Verbinders näher erläutert. Jedoch ist die Erfindung auch bei ähnlichen Anwendungsfällen von Gehäusen verwendbar.

Durch die neue Gehäuseausbildung ist sichergestellt, daß nach der Montage des Gehäuses stets eine gute Verrastung zwischen den Gehäuseteilen vorliegt. Selbst wenn der pfeilspitzartige Teil der Schnappverbindung einmal verbogen, insbesondere zusammengedrückt, sein sollte, wird er durch die erfindungsgemäße Ausbildung während der Montage wieder in die ordnungsgemäße Verrastungsstellung auseinandergedrückt. Plastische Verformungen können somit nicht mehr zu Fehlfunktionen der Verrastung führen, sondern werden infolge der erfindungsgemäßen Ausbildung und Anordnung beseitigt und damit wirkungslos.

Darüber hinaus wird die Verbindungskraft oder Haltekraft zwischen den Gehäuseteilen erhöht; d. h. es ist eine wesentlich höhere Trennkraft aufzuwenden, um die Gehäuseteile voneinander zu trennen. Beim Aufbringen einer Trennkraft auf einen der Gehäuseteile in Richtung entgegengesetzt zur Pfeilrichtung kann das elastische pfeilspitzartige Teil nicht ohne weiteres zusammengedrückt werden. Dieser stützt sich über die Pfeilspitze am anderen Gehäuseteil ab und widersetzt sich damit einem Zusammendrücken. Schließlich ist dadurch, daß das pfeilspitzartige Verriegelungsteil gegen einen Teil des anderen Gehäuseteils drückt, dieser Verriegelungsteil gegen äußere Einwirkungen geschützt, so daß ein unbeabsichtigtes Lösen der Verriegelung ausgeschlossen ist.

In der Zeichnung ist ein Ausführungsbeispiel der Erfindung dargestellt, das im folgenden näher beschrieben wird.
- Figur 1: zeigt den Grundkörper eines Gehäuses für einen elektrischen Steckverbinder in Seitenansicht.
- Figur 2: zeigt den Grundkörper nach Figur 1 in Stirnansicht, d. h. von links gesehen.
- Figur 3: zeigt den Grundkörper nach Figur 1 von unten gesehen.
- Figur 4: zeigt den Deckel für den Grundkörper nach den Figuren 1 bis 3 in Seitenansicht.
- Figur 5: zeigt den Deckel nach Figur 4 in Stirnansicht, d. h. von links gesehen.
- Figur 6: zeigt den Deckel nach Figur 5 in Draufsicht.
- Figur 7: zeigt den Zusammenbau des Gehäuses aus Grundkörper und Deckel für einen Steckverbinder.
- Figur 8: zeigt das Gehäuse nach Figur 7 in Seitenansicht, d. h. von links gesehen, mit einem Steckkontakt.
- Figur 9: zeigt den Schnitt IX-IX durch das Gehäuse nach Figur 8.

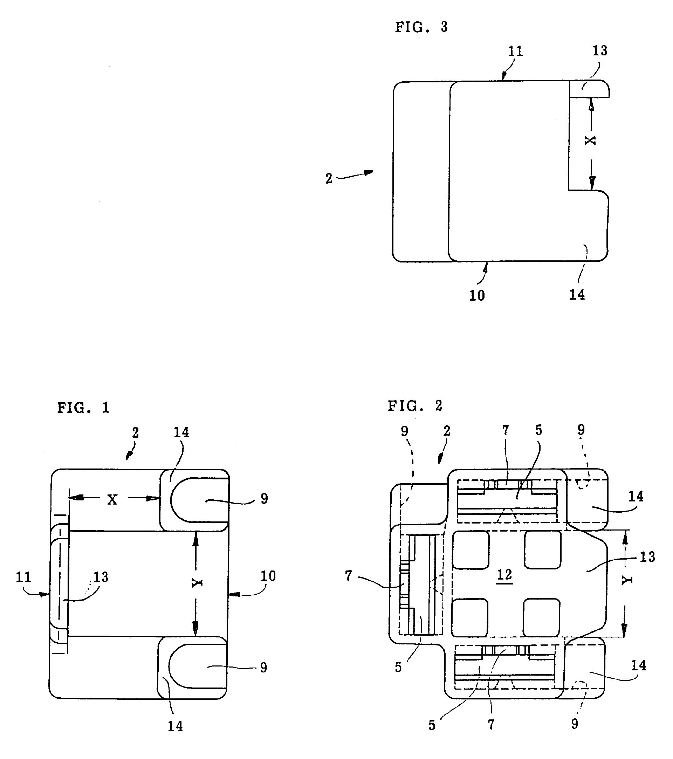

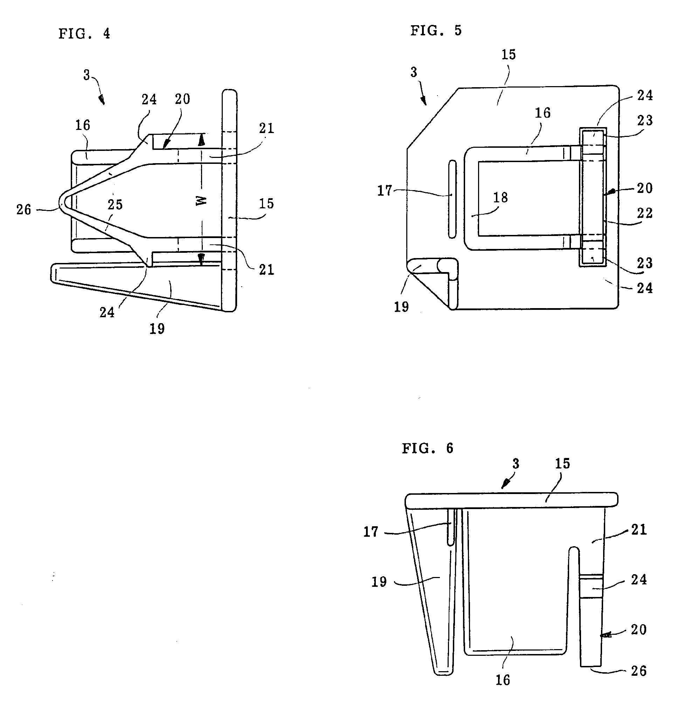

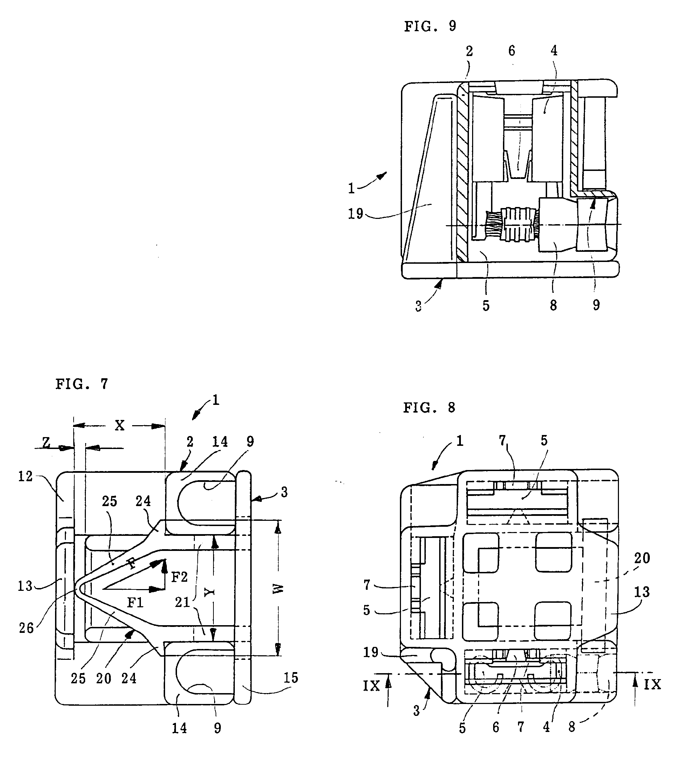

Das Steckergehäuse 1 ist zusammengesetzt aus einem Grundkörper 2 (Figuren 1 bis 3) und einem Deckel 3 (Figuren 4 bis 6). Das Gehäuse 1 umfaßt elektrische Steckkontakte 4, die als Winkelsteckhülsen ausgebildet sind (Figuren 7 bis 9). Die Steckkontakte 4 sind von hinten in drei Kammern 5 des Grundkörpers 2 eingesetzt und durch einen Sperrhaken 6, der sich an einer Stufe 7 der Kammer 5 abstützt, gegen Herausziehen gesichert. In den Figuren 8 und 9 ist einer der Steckkontakte eingezeichnet. Die Steckkontakte 4 sind an elektrische Leitungen 8 fest angeschlagen.

Die drei Kammern 5 des Grundkörpers 2 sind in U-Form zueinander angeordnet (Figur 2). Die elektrischen Leitungen treten seitlich über rinnenförmige Kanäle 9 aus den Kammern 5 aus. Die mit den Leitungen 8 verbundenen Steckkontakte 4 können demnach leicht von der hinteren Seite 10 in den Grundkörper 2 eingesetzt werden.

An der Vorderseite 11 des Grundkörpers 2 ist eine Stirnwand 12 angeordnet, die einen Vorsprung 13 im Öffnungsbereich der U-Form aufweist. Im Abstand X zum Vorsprung 13 (Figur 1) erstrecken sich zwei Absätze 14, deren Abstand Y voneinander dem Abstand der U-Schenkel entspricht, vergleiche Figuren 1 und 2.

Der Deckel 3 (Figuren 3 bis 5) besteht im wesentlichen aus einer Abschlußplatte 15, die in ihrer Form dem Querschnitt des Grundkörpers 2 angepaßt ist. Von der Abschlußplatte 15 erstrecken sich senkrecht hierzu vier Vorsprünge. Ein erster Vorsprung 16 ist im wesentlichen U-förmig ausgebildet. Ein zweiter Vorsprung 17 ist erheblich kürzer, hat etwa die Breite des U-Stegs 18 des Vorsprungs 16 und ist außerhalb des U-Stegs 18 sowie mit geringem Abstand parallel dazu angeordnet. Ein dritter Vorsprung 19 ist nahe einer Ecke der Abschlußplatte 15 angeformt. Er ist im Querschnitt winkel- oder L-förmig ausgebildet, siehe Figur 5, und verjüngt sich im Querschnitt zu seinem Ende hin.

Ein vierter Vorsprung 20 erstreckt sich nahe der U-Öffnung des Vorsprungs 16. Er hat die Form einer Pfeilspitze, vergleiche Figur 4, ist jedoch als Rahmen, d. h. hohl, ausgebildet. An den hinteren Bereichen 21 ist der Vorsprung 20 sowohl mit der Abschlußplatte 15 als auch mit den Schenkeln des U-förmigen Vorsprungs 16 verbunden, vergleiche Figur 6. Zwischen den Bereichen 21 ist in der Abschlußplatte 15 eine Ausnehmung 22, neben den Bereichen 21 sind ebenfalls zwei Ausnehmungen 23 angeordnet. Sie erleichtern die Formgebung des Vorsprungs 20.

An die hinteren Bereiche 21 schließen sich Widerhaken 24 an, von denen zwei Schenkel 25 ausgehen, die sich in der Spitze 26 vereinigen. Die Schenkel 25 verjüngen sich im Querschnitt zur Spitze 26 hin, vergleiche Figur 4.

Der Zusammenbau des Gehäuses 1 läuft folgendermaßen ab: Drei an elektrische Leitungen 8 angeschlagene Steckkontakte 4 werden in die Kammern 5 eingeschoben, bis sich die Sperrhaken 6 hinter den Stufen 5 verrasten (erste Verriegelung der Steckkontakte 4). Die Leitungen 8 liegen dabei in den Kanälen 9. Der Deckel 3 wird von hinten, von der Seite 10, in den Grundkörper 2 eingeschoben. Dabei dienen die Vorsprünge 16 bis zur 19 zur Führung und eindeutigen Zuordnung des Deckels zum Grundkörper 2. Beim Einschieben werden die Schenkel 25 zwischen die Absätze 14 geführt. Da der Abstand X (Figur 7) zwischen den Widerhaken 24 größer ist als der Abstand Y zwischen den Absätzen 14, wird der Vorsprung 20 im Bereich der Schenkel 25 und der Widerhaken 24 zusammengedrückt, bis die Widerhaken 24 zwischen die Absätze 14 passen. Wenn der Abstand W = Y ist, kann der Vorsprung 20 mit seiner Spitze 26 und den Schenkeln 25 die Absätze 14 passieren. Dabei wirken die Vorsprünge 16 und 17 als innere, der Vorsprung 19 als äußere Führungsglieder, vergleiche die Figuren 7 bis 9.

Am Ende des Einschiebvorganges geschieht folgendes: Zunächst stößt die Spitze 26 des Deckels 3 auf den Vorsprung 13 des Grundkörpers 2. Dann verbiegen sich die Schenkel 25 bei weiterem Verschieben etwas nach außen, und die Widerhaken 24 schnappen hinter die Absätze 14 des Grundgehäuses 2.

Durch Vorsehen des Abstandes Z (Figur 7) zwischen der Stirnwand 12 des Grundkörpers 2 und dem U-förmigen Vorsprung 16 des Dekkels 3 ist sichergestellt, daß sich der Vorsprung 20 mit seiner Spitze 26 und seinen Widerhaken 24 zwischen dem Vorsprung 13 der Stirnwand 12 und den Absätzen 14 des Grundkörpers 2 verspannen kann.
Das hat zur Folge, daß sich die von der Spitze 26 ausgehende Kraft F in eine axiale Teilkraft F1 und in eine dazu quergerichtete Teilkraft F2 aufteilt, vergleiche Kräftedreieck in Figur 7. Die Kraft F2 bewirkt nun, daß die Widerhaken 24 auseinandergedrückt werden. Mit anderen Worten: Die Kraft F2 setzt sich einer eventuellen außen aufgebrachten oder auftretenden Lösekraft entgegen. Denn zum Lösen müssen die Widerhaken 24 sich erst wieder annähern, damit Abstand W wieder gleich Y wird, vergleiche Figur 7. Wird z. B. auf die Steckkontakte 4 oder auf ihre Leitungen 8 eine Kraft in Richtung auf die Abschlußplatte 15 des Deckels 3 ausgeübt, so stemmen sich die Schenkel 25 einem Verringern des Abstandes W entgegen. Dies bewirkt eine größere Haltekraft, die erst bei außergewöhnlich hohen äußeren Kräften überwunden werden kann. In der Regel dürfte in derartigen Fällen jedoch schon die angeschlossene Leitung 8 zerreißen, bevor sich die Schnappverbindung der Widerhaken 24 löst.
Als Material für die Gehäuseteile kommen übliche im Spritzgießverfahren verarbeitbare Kunststoffe in Betracht. Hauptvoraussetzung ist, daß die Gehäuseteile zäh-elastisch ausgebildet sind, wobei jedoch, wie oben schon erwähnt, auch Deformationen der vorfabrizierten Teile die gute Verriegelung der Gehäuseteile nicht beeinträchtigen können. Während im beschriebenen Beispiel von zwei getrennten Gehäuseteilen ausgegangen wird, kann die Erfindung aber auch dann verwendet werden, wenn beide Gehäuseteile zusammen gespritzt und z. B. über ein Filmscharnier oder dergleichen miteinander verbunden sind.

### Bezugszeichenliste

- 1: Steckergehäuse
- 2: Grundkörper
- 3: Deckel
- 4: Steckkontakte
- 5: Kammern
- 6: Sperrhaken
- 7: Stufe
- 8: elektrische Leitung
- 9: Kanäle
- 10: Hinterseite von 2
- 11: Vorderseite von 2
- 12: Stirnwand
- 13: Vorsprung
- 14: Absätze
- 15: Abschlußplatte
- 16: 1. Vorsprung
- 17: 2. Vorsprung
- 18: U-Steg von 16
- 19: 3. Vorsprung
- 20: 4. Vorsprung
- 21: hintere Bereiche
- 22: Ausnehmung
- 23: Ausnehmungen
- 24: Widerhaken
- 25: Schenkel
- 26: Spitze
- W: Abstand zwischen 24
- X: Abstand zwischen 13 und 14
- Y: Abstand zwischen 14
- Z: Abstand zwischen 12 und 16
- F: Kraft
- F1: Teilkraft
- F2: Teilkraft

## Patentansprüche

1. Gehäuse (1)
- aus einem Grundkörper (2) zur Aufnahme von elektrischen Bauteilen (4),
- und aus einem den Grundkörper (2) zumindest auf einer Seite verschließenden Deckel (3),
- mit einer Verriegelungsvorrichtung (14, 24) zwischen dem Grundkörper (2) und dem Deckel (3),
-- die aus mindestens einem elastischen, hohlen, pfeilspitzartigen Teil (Vorsprung 20) besteht,
--- der beim Verbinden sich zunächst zusammendrücken läßt, jedoch dann sich elastisch spreizend mit Widerhaken (24) hinter zwei Absätze (14) des anderen Gehäuseteils (Grundkörper 2 oder Deckel 3) greift und die Verbindung der Gehäuseteile (2, 3) sichert,
dadurch gekennzeichnet, daß die Spitze (26) des pfeilspitzartigen Teils (Vorsprung 20) nach dem Verbinden unter Spannung an dem anderen Gehäuseteil (Vorsprung 13) so anliegt, daß von der Spitze (26) ausgehend eine Kraft (F 2) auf die Widerhaken (24) gerichtet ist, welche die Widerhaken (24) auseinander zu bewegen bestrebt ist.

2. Gehäuse nach Anspruch 1, dadurch gekennzeichnet, daß der pfeilspitzartige Teil (20) am Deckel (3) und am Grundkörper (2) ein Vorsprung (13) angeordnet ist, gegen den die Spitze (26) zur Anlage kommt.

3. Gehäuse nach Anspruch 1 oder 2, dadurch gekennzeichnet, daß der Deckel (3) mindestens ein Führungsglied (16 bis 19) aufweist, das sich in Pfeilrichtung erstreckt.

4. Gehäuse nach Anspruch 3, dadurch gekennzeichnet, daß das Führungsglied (16 bis 19) im Querschnitt eine L- oder U-Form aufweist (Fig. 5).

5. Gehäuse nach Anspruch 3 oder 4, dadurch gekennzeichnet, daß das Führungsglied bzw. die Führungsglieder (16 bis 19) innerhalb und/oder außerhalb des Grundkörpers (2) angeordnet ist bzw. sind.

6. Elektrischer Steckverbinder mit einem Gehäuse nach einem der Ansprüche 1 bis 5, dadurch gekennzeichnet, daß im Gehäuse (1) mindestens ein Steckkontakt (4) angeordnet ist, der durch den Deckel (3) allein oder zusätzlich im Grundkörper (2) gehalten ist.

7. Verbinderanordnung mit einem elektrischen Steckverbinder nach Anspruch 6, dadurch gekennzeichnet,
- daß drei Kammern (5) und drei Steckkontakte (4) in U-Form angeordnet sind,
- daß die Steckkontakte (4) als Winkelsteckhülsen ausgebildet sind,
- daß die Winkelsteckhülsen fest mit elektrischen, isolierten Leitungen (8) verbunden sind,
- daß die elektrischen Leitungen (8) in rinnenförmige Kanäle (9) des Grundkörpers (2) eingelegt sind und
- daß die Kammern (5) und die Kanäle (9) von dem Deckel (3) abgedeckt sind.

## Claims

1. A housing (1)
- of a basic structure (2) for receiving electrical components (4),
- and of a lid (3) locking the basic structure (2) at least on one side,
- with a locking device (14, 24) between the basic structure (2) and the lid (3),
- the locking device (14, 24) comprising at least one resilient, hollow, arrowhead-like part (projection 20),
- which can be initially pressed together during connection, but then engages behind two recesses (14) of the other housing part (basic structure 2 or lid 3) by expanding resiliently with barbs (24) and ensures the connection of the housing parts (2, 3),
**characterised in that** the peak (26) of the arrowhead-like part (projection 20) after connecting under tension to the other housing part (projection 13) fits in such a way that a force (F2) coming out from the peak (26) is directed to the barbs (24) and has a tendency to move the barbs (24) apart.

2. A housing according to Claim 1, **characterised in that** the arrowhead-like part (20) is arranged on the lid (3) and on the basic structure (2) a projection (13) is arranged against which the peak (26) comes to rest.

3. A housing according to Claim 1 or 2, **characterised in that** the lid (3) has at least one guide element (16 to 19) which extends in the direction of the arrow.

4. A housing according to Claim 3, **characterised in that** the cross-section of the guide element (16 to 19) is L or U shaped (Fig. 5).

5. A housing according to Claim 3 or 4, **characterised in that** the guide element or the guide elements (16 to 19) is or are arranged inside and/or outside the basic structure (2).

6. An electrical connector with a housing according to one of Claims 1 to 5, **characterised** **in that** in the housing (1) at least one plug contact (4) is arranged, which is supported solely and additionally by the lid (3) in the basic structure (2).

7. A connector arrangement with an electrical connector according to Claim 6, **characterised in that**
- three cavities (5) and three plug contacts (4) are arranged in a U shape,
- the plug contacts (4) are in the form of right angle plug bushes,
- the right angle plug bushes are securely connected to electric insulated lines (8),
- the electric lines (8) are inserted in groove-shaped channels (9) of the basic structure (2) and
- the cavities (5) and the channels (9) are covered by the lid (3).

## Revendications

1. Boîtier (1)
- comprenant un corps d'embase (2) pour recevoir des composants électriques (4),
- et un couvercle (3) obturant le corps d'embase (2) sur au moins un côté,
- avec interposition, entre le corps d'embase (2) et le couvercle (3), d'un système de verrouillage (14, 24)
-- constitué d'au moins une pièce élastique (saillie 20) creuse, du type pointe de flèche
--- qui est tout d'abord comprimée au stade de la liaison, mais s'engage toutefois ensuite par des ardillons (24), en se déployant élastiquement, derrière deux mentonnets (14) de l'autre partie du boîtier (corps d'embase 2 ou couvercle 3), et assure la solidarisation des parties (2, 3) du boîtier,
caractérisé par le fait que, après la solidarisation, la pointe (26) de la pièce (saillie 20) du type pointe de flèche est appliquée, avec tension, contre l'autre partie du boîtier (protubérance 13), de telle sorte qu'une force (F2), partant de la pointe (26) et dirigée vers les ardillons (24), ait tendance à déplacer lesdits ardillons (24) à l'écart l'un de l'autre.

2. Boîtier selon la revendication 1, caractérisé par le fait que la pièce (20) du type pointe de flèche est disposée sur le couvercle (3), le corps d'embase (2) présentant une protubérance (13) contre laquelle la pointe (26) vient s'appliquer.

3. Boîtier selon la revendication 1 ou 2, caractérisé par le fait que le couvercle (3) comporte au moins un organe de guidage (16 à 19) s'étendant dans la direction de la flèche.

4. Boîtier selon la revendication 3, caractérisé par le fait que l'organe de guidage (16 à 19) présente, en coupe transversale, une configuration en L ou en U (figure 5).

5. Boîtier selon la revendication 3 ou 4, caractérisé par le fait que l' (les) organe(s) de guidage (16 à 19) est (sont) disposé(s) à l'intérieur et/ou à l'extérieur du corps d'embase (2).

6. Connecteur électrique enfichable équipé d'un boîtier selon l'une des revendications 1 à 5, caractérisé par le fait qu'au moins un contact enfichable (4) logé dans le boîtier (1) est retenu, dans le corps d'embase (2), uniquement ou additionnellement par l'intermédiaire du couvercle (3).

7. Dispositif de connexion comportant un connecteur électrique enfichable selon la revendication 6, caractérisé par le fait
- que trois compartiments (5) et trois contacts enfichables (4) sont agencés en décrivant la forme d'un U,
- que les contacts enfichables (4) sont réalisés sous la forme de douilles d'enfichage en cornière,
- que les douilles d'enfichage en cornière sont reliées rigidement à des conducteurs électriques isolés (8),
- que les conducteurs électriques (8) sont encastrés dans des canaux (9) du corps d'embase (2), configurés en des saignées, et
- que les compartiments (5) et les canaux (9) sont recouverts par le couvercle (3).
